# FASCICULE DE BREVET EUROPEEN

(11) **EP 2 498 286 B1**
(45) Date de publication et mention de la délivrance du brevet: **07.08.2013**
(21) Numéro de dépôt: 12158624.2
(22) Date de dépôt: 08.03.2012
(51) Int. Cl.: H01L 21/762

(54) **PROCEDE DE TRAITEMENT D'UNE STRUCTURE DE TYPE SEMI-CONDUCTEUR SUR ISOLANT**
Behandlungsverfahren einer Struktur vom Typ Halbleiter auf einem Isoliermaterial
Method for treating a semiconductor structure on an insulator

(30) Priorité: 08.03.2011 FR 1151884
(43) Date de publication de la demande: 12.09.2012
(73) Titulaire: Soitec, 38190 Bernin (FR)
(72) Inventeur: Landru, Didier, 38190 CHAMP PRES FROGES (FR)
(74) Mandataire: Regimbeau

(56) Documents cités:
- WO-A1-2008/114099
- FR-A1- 2 937 794
- FR-A1- 2 937 797

## Description

### DOMAINE DE L'INVENTION

La présente invention concerne un procédé de traitement d'une structure de type semi-conducteur sur isolant (SeOl), comprenant successivement un substrat support, une couche d'oxyde ou d'oxynitrure d'un matériau semi-conducteur et une couche mince semi-conductrice dudit matériau semi-conducteur, dans lequel on applique un traitement thermique dans une atmosphère réduite en oxygène, et dans des conditions de température et de durée contrôlées, de manière à inciter au moins une partie de l'oxygène de la couche d'oxyde ou d'oxynitrure à diffuser à travers la couche mince semi-conductrice, ce qui conduit à la dissolution (i.e. la disparition) totale ou partielle de la couche enterrée d'oxyde ou d'oxynitrure.

### ARRIERE PLAN DE L'INVENTION

Le traitement mentionné plus haut peut avantageusement être appliqué de manière locale, c'est-à-dire pour dissoudre - partiellement ou en totalité - la couche d'oxyde ou d'oxynitrure dans des régions déterminées de la structure SeOl, correspondant à un motif désiré, tout en conservant dans les autres régions la couche d'oxyde ou d'oxynitrure initiale.

On parle alors de « dissolution locale » de la couche d'oxyde ou d'oxynitrure.

On précise que l'on entend par « oxynitrure » un composé de formule générale (Se)OₓN_{y} où Se est le symbole du matériau semi-conducteur considéré (par exemple, du silicium) et où x et y sont les teneurs respectives, non nulles, en oxygène et en azote. L'oxyde correspond au cas où y=0.

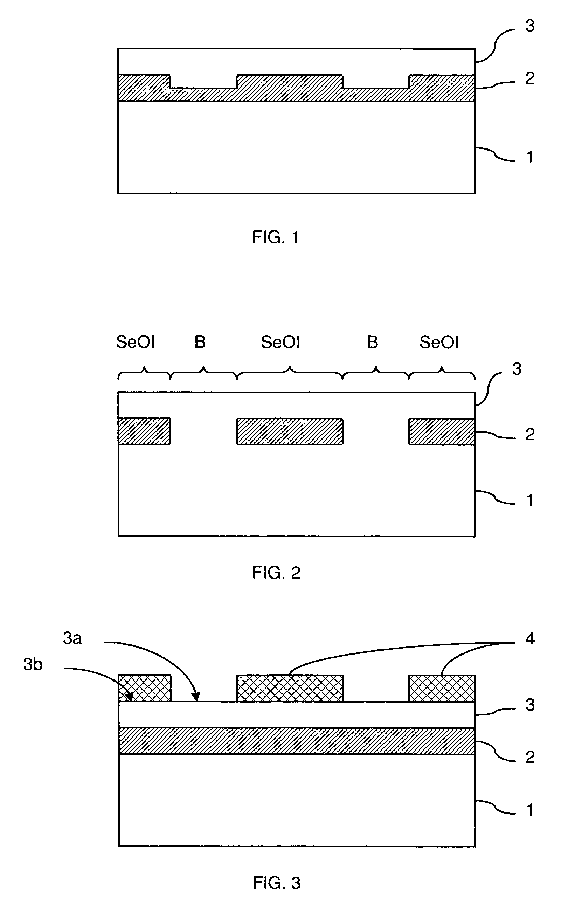

Grâce à un tel traitement, on peut obtenir, comme illustré à la figure 1, une structure SeOl présentant une couche d'oxyde ou d'oxynitrure avec des épaisseurs variables (dans le cas d'une dissolution partielle) ou bien, comme illustré à la figure 2, une structure hybride, c'est-à-dire comprenant à la fois des zones « SeOl », dans lesquelles la couche d'oxyde ou d'oxynitrure a été conservée et des zones dans lesquelles cette couche a été totalement dissoute.

Dans le cas d'une couche d'oxynitrure, l'azote diffuse également à travers la couche mince de matériau semi-conducteur, de sorte qu'à l'issue du traitement de dissolution, l'oxyde ou l'oxynitrure est transformé en le matériau semi-conducteur considéré.

La structure SeOl de la figure 1 comprend un substrat support 1, une couche 2 d'oxyde ou d'oxynitrure dont l'épaisseur a localement été diminuée par le traitement de dissolution, et une couche mince semi-conductrice 3.

La structure hybride de la figure 2 comprend un substrat support 1 et une couche mince semi-conductrice 3, entre lesquels la couche 2 d'oxyde ou d'oxynitrure a été conservée dans certaines régions (permettant de constituer des zones « SeOl »), et totalement dissoute dans d'autres (permettant de constituer des zones massives semi-conductrices référencées B).

Une telle structure peut être employée pour la fabrication de composants électroniques (par exemple, composants « mémoire » et composants logiques), qui requièrent des substrats différents sur une même plaque.

En d'autres termes, elle permet la co-intégration de circuits fonctionnant respectivement sur substrat SeOl et sur substrat massif (ou « bulk » selon la terminologie anglo-saxonne) au sein d'une même puce.

L'intérêt de la dissolution locale est donc de fournir à un fabricant de circuits intégrés une plaque comprenant des zones « bulk » et « SeOl » sur lesquelles il pourra fabriquer, en conservant les technologies qu'il maîtrise, à la fois des composants nécessitant une zone « bulk » et des composants nécessitant une zone « SeOl ».

La précision de la technique de dissolution locale permet en effet de maîtriser, à l'échelle des composants, les zones « bulk » et les zones « SeOl ».

La dissolution locale est généralement mise en oeuvre en formant un masque à la surface de la couche mince semi-conductrice, puis en appliquant le traitement thermique favorisant la diffusion de l'oxygène de la couche d'oxyde ou d'oxynitrure vers la surface de la couche semi-conductrice.

Le masque étant généralement réalisé dans un matériau constituant une barrière totale ou partielle à la diffusion de l'oxygène, l'oxygène ne peut diffuser aisément qu'à travers les zones de la couche mince semi-conductrice exposées, c'est-à-dire non recouvertes par le masque. Dans le cas où le masque permet une diffusion partielle de l'oxygène, il procure néanmoins une vitesse de dissolution beaucoup plus faible que celle des zones exposées (dépourvues de masque), dans lesquelles la dissolution est plus aisée en raison de l'absence de masque.

Le document WO 2008/114099 décrit un tel procédé, dans lequel le masque est obtenu par oxydation et bloque complètement la diffusion.

Toutefois, l'utilisation d'un tel masque peut présenter certains inconvénients dont l'apparition, dans la couche mince semi-conductrice, de tranchées au niveau du bord du masque.

Ces tranchées peuvent avoir plusieurs origines : mouillage du masque par le matériau semi-conducteur, réaction entre le masque et le matériau semi-conducteur...

Dans tous les cas, c'est l'importante mobilité de surface des atomes de semi-conducteur qui est responsable de la création de ces tranchées.

Ladite mobilité de surface dépend de la température et de l'atmosphère réductrice ou faiblement oxydante du traitement.

Ces défauts de topographie, dont la profondeur peut atteindre l'épaisseur de la couche semi-conductrice, sont préjudiciables à la fabrication de composants sur la couche mince semi-conductrice.

En particulier, les défauts en bord de masque amplifient la variation de topographie de surface.

Cette variation rend difficile la réalisation des étapes ultérieures de fabrication des circuits et peut conduire à des phénomènes de démouillage (ou « dewetting » selon la terminologie anglo-saxonne) du matériau semi-conducteur, c'est-à-dire de perte de cohésion de la couche mince de matériau semi-conducteur qui se dissocie pour former des gouttelettes à la surface de la couche d'oxyde ou d'oxynitrure.

Pour supprimer ou minimiser ces défauts de topographie, un polissage de type mécano-chimique visant à planariser la surface (pour éviter les différences de niveau liées à l'affaissement de la couche semi-conductrice), est difficilement envisageable car il retirerait une épaisseur trop importante de la couche semi-conductrice, l'épaisseur initiale de cette couche étant choisie mince pour faciliter la diffusion de l'oxygène.

En outre, le polissage tend à détériorer l'uniformité de l'épaisseur de la couche semi-conductrice.

On cherche donc à définir un procédé de dissolution localisée de la couche d'oxyde ou d'oxynitrure qui ne présente pas les inconvénients susmentionnés.

Un but de l'invention est ainsi de procurer un procédé de dissolution locale à l'issue duquel la topographie de la surface de la couche mince semi-conductrice soit améliorée.

### BREVE DESCRIPTION DE L'INVENTION

Conformément à l'invention, il est proposé un procédé de traitement d'une structure de type semi-conducteur sur isolant, comprenant successivement un substrat support, une couche d'oxyde ou d'oxynitrure d'un matériau semi-conducteur et une couche mince semi-conductrice dudit matériau semi-conducteur, ledit procédé comprenant les étapes suivantes :
(i) formation, à la surface de la couche mince, d'un masque de manière à définir des régions de la couche mince dites exposées, non recouvertes par le masque, réparties selon un premier motif, et des régions couvertes par le masque, réparties selon un second motif complémentaire du premier,
(ii) application d'un traitement thermique dans une atmosphère neutre ou réductrice, et dans des conditions de température et de durée contrôlées, de manière à inciter au moins une partie de l'oxygène de la couche d'oxyde ou d'oxynitrure à diffuser à travers les régions exposées de la couche mince semi-conductrice, conduisant à diminuer l'épaisseur d'oxyde ou d'oxynitrure dans des régions de la couche d'oxyde ou d'oxynitrure réparties selon ledit premier motif,
ledit procédé étant **caractérisé en ce qu'**avant ou pendant l'étape (ii) on forme sur les régions exposées une couche de nitrure ou d'oxynitrure du matériau semi-conducteur de la couche mince, l'épaisseur de ladite couche de nitrure ou d'oxynitrure étant telle que le ratio entre la vitesse de diffusion de l'oxygène à travers les régions exposées de la couche mince recouvertes de ladite couche (5) de nitrure ou d'oxynitrure et la vitesse de diffusion de l'oxygène à travers les régions recouvertes par le masque soit supérieur ou égal à 2.

Selon une première forme d'exécution de l'invention, l'étape de formation de la couche de nitrure ou d'oxynitrure du matériau semi-conducteur de la couche mince est réalisée préalablement à l'application du traitement thermique de l'étape (ii).

De manière alternative, l'étape de formation de la couche de nitrure ou d'oxynitrure du matériau semi-conducteur de la couche mince est réalisée pendant au moins une partie du traitement thermique de l'étape (ii).

La formation de la couche de nitrure ou d'oxynitrure du matériau semi-conducteur de la couche mince peut être obtenue par l'un des moyens suivants :
- exposition des régions exposées de la couche mince à une atmosphère contenant de l'azote,
- application d'un plasma azote à ladite couche mince,
- application d'un recuit dans une atmosphère contenant de l'azote.

Selon une variante, l'atmosphère du traitement thermique de l'étape (ii) contient de l'azote, de telle sorte que lors de l'étape (ii) il se forme à la surface des régions exposée une couche de nitrure ou d'oxynitrure du matériau semi-conducteur de la couche mince.

Ainsi, le traitement de l'étape (ii) peut être réalisé pendant une durée comprise entre 5 et 500 minutes, à une température comprise entre 1100 et 1300°C, dans une atmosphère qui contient de l'azote avec une concentration préférentiellement comprise entre 0,1 et 1 %.

### BREVE DESCRIPTION DES DESSINS

D'autres caractéristiques et avantages de l'invention ressortiront de la description détaillée qui va suivre, en référence aux dessins annexés sur lesquels :
- la figure 1 est une vue en coupe d'un premier type de structure obtenue par l'invention,
- la figure 2 est une vue en coupe d'un deuxième type de structure obtenue par l'invention,
- la figure 3 illustre un premier mode de réalisation du masque sur la couche mince semi-conductrice selon un motif déterminé,
- la figure 4 illustre la formation d'une couche de nitrure ou d'oxynitrure sur les zones exposées de la couche mince semi-conductrice de la structure de la figure 3,
- la figure 5 illustre un deuxième mode de réalisation du masque sur la couche mince semi-conductrice selon un motif déterminé,
- la figure 6 illustre la formation d'une couche de nitrure ou d'oxynitrure sur les zones exposées de la couche mince semi-conductrice de la structure de la figure 5.

Pour faciliter la représentation, les rapports entre les épaisseurs des différentes couches n'ont pas nécessairement été respectés.

### DESCRIPTION DETAILLEE DE L'INVENTION

### Structure semi-conducteur sur isolant

En référence à la figure 3, le traitement de dissolution est appliqué à une structure de type semi-conducteur sur isolant (SeOl), comprenant successivement de sa base vers sa surface un substrat support 1, une couche 2 d'oxyde ou d'oxynitrure de semi-conducteur et une couche semi-conductrice 3, qui a été préalablement recouverte d'un masque localisé.

Le substrat support 1 joue essentiellement un rôle de raidisseur de la structure SeOl.

A cet effet, il présente typiquement une épaisseur de l'ordre de quelques centaines de micromètres.

Le substrat support peut être un substrat massif ou bien composite, c'est-à-dire constitué d'un empilement d'au moins deux couches de matériaux différents.

Le substrat support peut ainsi comprendre l'un des matériaux suivants : Si, GaN, saphir, dans leurs formes monocristalline ou polycristalline.

La couche semi-conductrice 3 comprend au moins un matériau semi-conducteur, tel que Si, Ge ou SiGe.

La couche semi-conductrice 3 peut éventuellement être composite, c'est-à-dire constituée d'un empilement de couches de matériaux semi-conducteurs.

Le matériau de la couche semi-conductrice peut être monocristallin, polycristallin ou amorphe. Il peut être poreux ou non, dopé ou non.

De manière particulièrement avantageuse, la couche semi-conductrice est adaptée pour recevoir des composants électroniques.

La couche mince semi-conductrice présente une épaisseur comprise entre 5 et 200 nm, préférentiellement entre 30 et 100 nm, pour permettre une diffusion suffisamment rapide de l'oxygène.

La couche d'oxyde ou d'oxynitrure 2 est enterrée dans la structure, entre le substrat support 1 et la couche semi-conductrice 3 ; elle est donc généralement désignée, dans le langage du métier, par l'acronyme BOX (« Buried Oxyde layer »).

La couche 2 est formée d'un oxyde ou d'un oxynitrure du matériau semi-conducteur qui compose la couche mince 3, de manière à ce que la décomposition dudit nitrure ou oxynitrure dans la couche mince puisse se produire.

Afin de limiter la durée du traitement de dissolution, la couche d'oxyde ou d'oxynitrure de la structure SeOl présente en général une épaisseur fine ou ultrafine, c'est-à-dire entre 5 et 100 nm, de préférence entre 10 et 25 nm.

La structure SeOl est fabriquée par toute technique de report de couches connue de l'homme du métier, impliquant un collage.

On peut citer parmi ces techniques le procédé Smart Cut™ qui comprend principalement les étapes suivantes :
i) formation d'une couche d'oxyde ou d'oxynitrure sur le substrat support ou sur un substrat donneur comprenant la couche semi-conductrice,
ii) formation d'une zone de fragilisation dans le substrat donneur, la zone de fragilisation définissant la couche mince semi-conductrice à transférer,
iii) collage du substrat donneur sur le substrat support, la couche d'oxyde ou d'oxynitrure étant située à l'interface de collage
iv) fracture du substrat donneur le long de la zone de fragilisation pour transférer la couche mince semi-conductrice sur le substrat support.

Ce procédé est connu de l'homme du métier et ne sera donc pas décrit en détail ici. On pourra se référer par exemple à « Silicon-On-Insulator Technology: Materials to VLSI, 2nd Edition » de Jean-Pierre Colinge, Kluwer Academic Publishers, p.50-51.

On peut également employer un procédé consistant à coller, sur le substrat support, un substrat donneur comprenant la couche semi-conductrice, l'un et/ou l'autre des substrats étant recouvert d'une couche d'oxyde ou d'oxynitrure, puis à réduire l'épaisseur du substrat donneur par sa face arrière de sorte à ne laisser sur le substrat support que la couche mince semi-conductrice.

La structure SeOl ainsi obtenue peut ensuite être soumise à des traitements classiques de finition (polissage, planarisation, nettoyage...).

Dans ces procédés de formation de la structure SeOl, la couche d'oxyde est formée sur le substrat donneur ou sur le substrat support par une oxydation thermique (auquel cas l'oxyde est un oxyde du matériau du substrat ayant subi l'oxydation) ou bien par un dépôt, par exemple d'oxyde de silicium (SiO₂).

La couche d'oxyde peut également être une couche d'oxyde natif, résultant d'une oxydation naturelle du substrat donneur et/ou du substrat support en contact avec l'atmosphère.

Tout procédé idoine peut être utilisé pour la formation d'une couche d'oxynitrure, comme par exemple un dépôt d'oxynitrure, une oxydation suivie d'une nitruration, ou bien encore un plasma azote sur oxyde.

En revanche, des essais réalisés sur les structures SOI obtenues par le procédé SIMOX n'ont pas permis d'observer de dissolution de l'oxyde, ce qui a été attribué à une qualité inférieure de l'oxyde, due à son mode d'obtention. On pourra se référer à cet égard à l'article de L. Zhong et al, Applied Physics Letters 67, 3951 (1995).

On précise qu'avant de procéder au collage, on peut mettre en oeuvre, sur l'une et/ou l'autre des surfaces en contact, des étapes de nettoyage ou d'activation plasma bien connues de l'homme du métier, afin de renforcer l'énergie de collage.

Dans la suite de la description, on prendra pour exemple l'application du traitement de dissolution à une structure dans laquelle la couche mince semi-conductrice 3 est en silicium, c'est-à-dire une structure « silicium sur isolant » (SOI).

### Formation du masque

Comme illustré à la figure 3, un masque 4 est formé à la surface de la couche mince 3 de manière à recouvrir les régions 3b de la surface à travers lesquels l'oxygène ne doit pas diffuser, ou pour le moins doit présenter une vitesse de diffusion très inférieure à celle des régions exposées 3a.

Les régions 3a de la surface de la couche mince 3 non recouvertes par le masque 4 sont dites « exposées ».

Lesdites régions 3a, qui doivent permettre la diffusion aisée de l'oxygène - et, le cas échéant, de l'azote - de la couche 2 d'oxyde ou d'oxynitrure, sont réparties suivant le motif selon lequel on souhaite dissoudre toute ou partie de l'épaisseur de la couche d'oxyde ou d'oxynitrure.

En d'autres termes, le masque 4 est réparti sur la couche mince 3 selon un motif complémentaire du motif selon lequel on souhaite dissoudre toute ou partie de l'épaisseur de la couche d'oxyde ou d'oxynitrure.

A cet effet, le masque est en un matériau formant barrière à l'oxygène venant du substrat.

La formation du masque peut être effectuée, par exemple mais non exclusivement, selon l'un des procédés décrits dans les documents WO 2008/114099 et WO 2010/034696.

Ainsi, selon un premier mode de réalisation, le masque est réalisé par un dépôt localisé de nitrure ou d'oxyde à la surface de la couche mince 3.

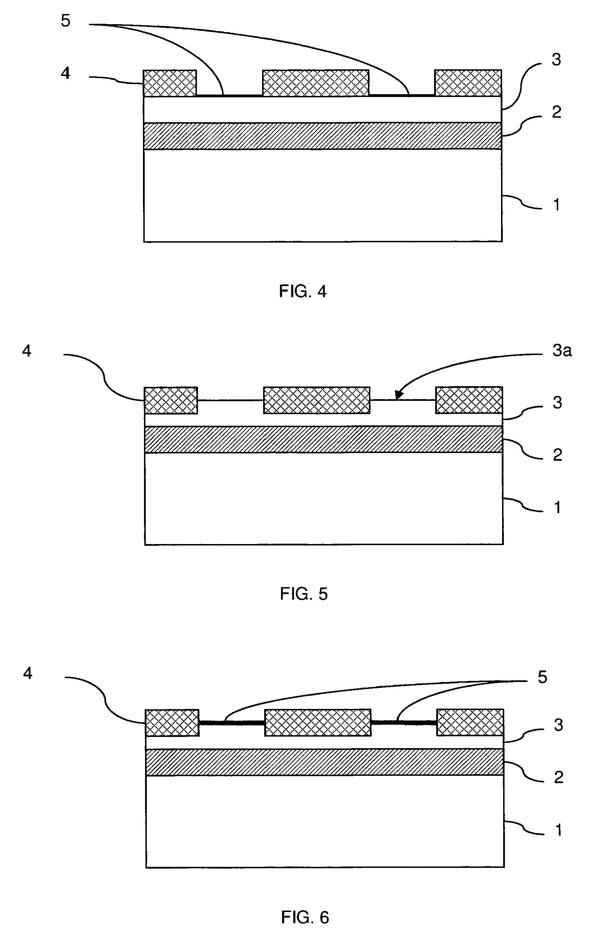

Selon un deuxième mode de réalisation, illustré à la figure 5, le masque est formé par oxydation thermique des zones de la couche mince 3b, les zones 3a destinées à former les zones exposées étant quant à elles protégées d'une telle oxydation.

Par rapport au mode de réalisation précédent, la formation d'un tel masque implique la consommation d'une faible épaisseur de la couche mince 3, ce qui conduit à « enterrer » partiellement le masque dans la couche mince 3.

Selon un troisième mode de réalisation (non illustré ici), le masque est constitué par des régions de la couche mince 3 qui sont plus épaisses que les régions à travers lesquelles doit se produire la diffusion des atomes d'oxygène et, le cas échéant, d'azote, de la couche enterrée d'oxyde ou d'oxynitrure.

### Traitement des régions exposées

En référence à la figure 4 ou, le cas échéant, à la figure 6, après la formation du masque 4, on applique aux régions exposées 3a de la couche mince 3 un traitement visant à former, à la surface desdites régions 3a, une fine couche 5 de nitrure ou d'oxynitrure du matériau semi-conducteur de la couche 3.

Selon un premier mode de réalisation, ledit traitement est réalisé préalablement à la mise en oeuvre du traitement thermique de dissolution.

Le traitement peut comprendre l'application d'un plasma azote.

A titre d'exemple, on applique un plasma N₂ de type RIE (acronyme du terme anglo-saxon « Reactive Ion Etching ») pendant 30 secondes à 500 W et une pression de 50 mTorr.

De manière alternative, le traitement peut comprendre un recuit azoté.

Par exemple, ledit recuit azoté est effectué à 1000°C, avec une atmosphère contenant 99% d'argon et 1% d'azote, pendant ½ heure.

Selon un deuxième mode de réalisation, le traitement des zones exposées est mis en oeuvre au cours du traitement thermique de dissolution.

A cet effet, on introduit de l'azote dans l'atmosphère neutre ou réductrice du traitement de dissolution pendant toute ou partie du traitement thermique.

La concentration en azote est typiquement comprise entre 0,1 et 1 %.

Par exemple, on réalise le traitement thermique de dissolution au moyen d'une atmosphère d'argon comprenant de 0,1 à 1 % d'azote, pendant 1 heure et à une température comprise entre 1100 et 1300°C.

La concentration en azote varie en fonction de la température : plus la température est élevée, plus la concentration est élevée.

L'épaisseur de la couche 5 de nitrure ou d'oxynitrure ainsi formée en surface des zones exposées 3a est typiquement comprise entre 1 et 10 nm.

Ceci permet d'obtenir un ratio entre la vitesse de diffusion de l'oxygène à travers les régions exposées 3a et la vitesse de diffusion de l'oxygène à travers les régions 3b recouvertes par le masque 4 qui soit supérieur ou égal à 2.

### Traitement thermique de dissolution

Lors du traitement thermique, la structure SOI est placée dans un four dans lequel on génère un flux gazeux pour former une atmosphère neutre ou réductrice.

Le flux gazeux peut ainsi comprendre de l'argon, de l'hydrogène et/ou un mélange de ceux-ci, et le cas échéant, de l'azote.

Il est important de noter que le phénomène de dissolution de la couche enterrée ne se produit que lorsqu'il existe un gradient suffisant entre la concentration d'oxygène dans l'atmosphère et la concentration d'oxygène à la surface de la couche d'oxyde ou d'oxynitrure, c'est-à-dire dans le cas d'une teneur en oxygène de l'atmosphère suffisamment faible.

Ainsi, on considère que la teneur en oxygène de l'atmosphère dans le four doit être inférieure à un certain seuil adapté, par exemple de l'ordre de 10 ppm, ce qui, tenant compte des fuites, impose une teneur en oxygène dans le flux de gaz inférieure à 1 ppb.

On pourra à cet égard se référer à l'article de Ludsteck et al, « Growth model for thin oxides and oxide optimization », Journal of Applied Physics, Vol. 95, No. 5, Mars 2004.

Ces conditions ne peuvent être obtenues dans un four classique, qui génère trop de fuites pour permettre d'atteindre une teneur aussi faible ; le four doit être spécialement conçu pour une étanchéité optimale (diminution du nombre de pièces pour éviter les joints, utilisation de pièces massives...).

Au contraire, une concentration en oxygène dans l'atmosphère trop élevée supérieure au seuil précité par exemple de l'ordre de 10 ppm, stoppe la dissolution et favorise une oxydation du silicium exposé.

Les mécanismes de dissolution de l'oxyde dans une structure SOI sont décrits en détail dans l'article d'O. Kononchuk et al, « Internal Dissolution of Buried Oxide in SOI Wafers », Solid State Phenomena Vols. 131-133 (2008) pp 113-118, auquel on pourra se référer.

Sous l'effet du traitement thermique, les atomes d'oxygène - et, le cas échéant, d'azote - de la couche d'oxyde ou d'oxynitrure diffusent à travers la couche mince 3, dans les régions recouvertes de la couche 5 de nitrure ou d'oxynitrure.

La couche 5 est suffisamment fine pour que, même si elle ralentit la diffusion, elle permette une diffusion plus rapide qu'à travers le masque 4.

On considère que, pour que la dissolution soit satisfaisante, le ratio entre la vitesse de diffusion à travers les régions recouvertes par la couche 5 et la vitesse à travers les régions recouvertes par le masque 4 doit être supérieur à 2 environ.

Dans les zones exposées, le ralentissement de la vitesse de dissolution dû à la présence de la couche 5 dépend en particulier du matériau de celle-ci et de son épaisseur.

La vitesse de diffusion de l'oxygène à travers la couche de surface est calculée à partir de la vitesse de dissolution de la couche d'oxynitrure enterrée.

Le modèle de dissolution est connu et calibré.

Lorsqu'il modifie la nature chimique de la surface, l'homme du métier est en mesure de déterminer l'effet de cette couche sur la diffusion de l'oxygène en mesurant l'écart entre la cinétique de dissolution observée et celle attendue en l'absence de toute modification.

Par ailleurs, la couche 5 a pour effet de diminuer la mobilité de surface des atomes de silicium ou du matériau semi-conducteur de la couche mince 3.

Ainsi, les défauts de topographie, la formation de tranchées et le démouillage mentionnés en introduction sont supprimés ou tout au moins diminués dans une grande mesure.

Ainsi, pour dissoudre une épaisseur d'oxyde de 2 nm sous une couche mince de silicium de 100 nm, les conditions du traitement thermique sont : 1100°C pendant 2 heures, 1200°C pendant 10 minutes, ou 1250°C pendant 4 minutes.

On notera toutefois que ces valeurs sont dépendantes en particulier de la concentration résiduelle en oxygène dans le four de dissolution et de la nature de la couche 5. Ainsi, des épaisseurs dissoutes plus importantes ont aussi été observées.

Après le traitement de dissolution, on procède au retrait du masque 4 et de la couche 5 de nitrure ou d'oxynitrure, par tout moyen approprié, tel qu'une gravure.

Ainsi, même si la formation de la couche 5 peut augmenter la rugosité de surface de la couche semi-conductrice 3, il est possible d'y remédier par exemple par une gravure chimique.

Enfin, une étape de planarisation est généralement nécessaire pour conférer à la couche mince 3 une surface plane et d'une rugosité adéquate. On peut employer à cet effet toute méthode appropriée (polissage, amincissement chimique...).

## Revendications

1. Procédé de traitement d'une structure de type semi-conducteur sur isolant, comprenant successivement un substrat support (1), une couche (2) d'oxyde ou d'oxynitrure d'un matériau semi-conducteur et une couche mince semi-conductrice (3) dudit matériau semi-conducteur, ledit procédé comprenant les étapes suivantes :
(i) formation, à la surface de la couche mince (3), d'un masque (4) de manière à définir des régions (3a) de la couche mince dites exposées, non recouvertes par le masque, réparties selon un premier motif, et des régions (3b) couvertes par le masque, réparties selon un second motif complémentaire du premier,
(ii) application d'un traitement thermique dans une atmosphère neutre ou réductrice, et dans des conditions de température et de durée contrôlées, de manière à inciter au moins une partie de l'oxygène de la couche (2) d'oxyde ou d'oxynitrure à diffuser à travers les régions exposées (3a) de la couche mince semi-conductrice, conduisant à diminuer l'épaisseur d'oxyde ou d'oxynitrure dans des régions (2b) de la couche d'oxyde ou d'oxynitrure (2) réparties selon ledit premier motif,
ledit procédé étant **caractérisé en ce qu'**avant ou pendant l'étape (ii) on forme sur les régions exposées (3a) une couche (5) de nitrure ou d'oxynitrure du matériau semi-conducteur de la couche mince (3), l'épaisseur de ladite couche (5) de nitrure ou d'oxynitrure étant telle que le ratio entre la vitesse de diffusion de l'oxygène à travers les régions exposées (3a) de la couche mince (3) recouvertes de ladite couche (5) de nitrure ou d'oxynitrure et la vitesse de diffusion de l'oxygène à travers les régions (3b) recouvertes par le masque (4) soit supérieur ou égal à 2.

2. Procédé selon la revendication 1, **caractérisé en ce que** l'étape de formation de la couche (5) de nitrure ou d'oxynitrure du matériau semi-conducteur de la couche mince (3) est réalisée préalablement à l'application du traitement thermique de l'étape (ii).

3. Procédé selon la revendication 1, **caractérisé en ce que** l'étape de formation de la couche (5) de nitrure ou d'oxynitrure du matériau semi-conducteur de la couche mince (3) est réalisée pendant au moins une partie du traitement thermique de l'étape (ii).

4. Procédé selon la revendication 2, **caractérisé en ce que** la formation de la couche (5) de nitrure ou d'oxynitrure du matériau semi-conducteur de la couche mince (3) est obtenue par exposition des régions exposées (3a) de la couche mince (3) à une atmosphère contenant de l'azote.

5. Procédé selon la revendication 4, **caractérisé en ce que** la formation de la couche (5) de nitrure ou d'oxynitrure du matériau semi-conducteur de la couche mince (3) est obtenue par application d'un plasma azote à ladite couche mince (3).

6. Procédé selon la revendication 4, **caractérisé en ce que** la formation de la couche (5) de nitrure ou d'oxynitrure du matériau semi-conducteur de la couche mince (3) est obtenue par application d'un recuit dans une atmosphère contenant de l'azote.

7. Procédé selon la revendication 3, **caractérisé en ce que** l'atmosphère du traitement thermique de l'étape (ii) contient de l'azote, de telle sorte que lors de l'étape (ii) il se forme à la surface des régions exposées (3a) une couche (5) de nitrure ou d'oxynitrure du matériau semi-conducteur de la couche mince (3).

8. Procédé selon la revendication 7, **caractérisé en ce que** le traitement de l'étape (ii) est réalisé pendant une durée comprise entre 5 et 500 minutes, à une température comprise entre 1100 et 1300°C, et **en ce que** l'atmosphère contient de l'azote avec une concentration préférentiellement comprise entre 0,1 et 1 %.

## Patentansprüche

1. Verfahren zur Behandlung einer Struktur vom Typ Halbleiter auf Isolator, die aufeinanderfolgend Folgendes umfasst: ein Trägersubstrat (1), eine Schicht (2) aus einem Oxid oder einem Oxidnitrid eines Halbleitermaterials und eine halbleitende Dünnschicht (3) aus diesem Halbleitermaterial, wobei das Verfahren die folgenden Phasen umfasst:
i. Ausbilden, auf der Oberfläche der Dünnschicht (3), einer Maske (4), und dies derart, dass Folgendes definiert wird: Bereiche (3a) der Dünnschicht, die als offenliegend bezeichnet und die nicht von der Maske abgedeckt werden, wobei diese entsprechend einem ersten Muster verteilt sind, und von der Maske abgedeckte Bereiche (3b), die entsprechend einem zweiten Muster verteilt sind, das komplementär zum ersten ist,
ii. Anwenden einer Wärmebehandlung in einer neutralen oder reduzierenden Atmosphäre und unter kontrollierten Bedingungen der Temperatur und der Dauer und derart, dass wenigstens ein Teil des Sauerstoffs der Oxid- oder Oxidnitrid-Schicht (2) dazu veranlasst wird, durch die offenliegenden Bereiche (3a) der halbleitenden Dünnschicht hindurch zu diffundieren, wodurch eine Verringerung der Oxid- oder Oxidnitriddicke in Bereichen (2b) der Oxid- oder Oxidnitrid-Schicht (2) bewirkt wird, die entsprechend dem ersten Muster verteilt sind,
wobei das Verfahren **dadurch gekennzeichnet ist, dass** vor oder während der Phase (ii) auf den offenliegenden Bereichen (3a) eine Schicht (5) aus einem Nitrid oder Oxidnitrid des Halbleitermaterials der Dünnschicht (3) gebildet wird, wobei die Dicke der Nitrid- oder Oxidnitridschicht (5) derart ist, dass das Verhältnis der Diffusionsgeschwindigkeit des Sauerstoffs durch die offenliegenden Bereiche (3a) der Dünnschicht (3) hindurch, die von der Nitrid- oder Oxidnitridschicht (5) abgedeckt sind, zur Diffusionsgeschwindigkeit des Sauerstoffs durch die Bereiche (3b) hindurch, die von der Maske (4) abgedeckt sind, größer oder gleich 2 ist.

2. Verfahren nach Anspruch 1, **dadurch gekennzeichnet, dass** die Phase zum Bilden der Nitrid- oder Oxidnitridschicht (5) des Halbleitermaterials der Dünnschicht (3) vor der Anwendung der Wärmebehandlung der Phase (ii) ausgeführt wird.

3. Verfahren nach Anspruch 1, **dadurch gekennzeichnet, dass** die Phase zum Bilden der Nitrid- oder Oxidnitridschicht (5) des Halbleitermaterials der Dünnschicht (3) während wenigstens eines Teils der Wärmebehandlung der Phase (ii) ausgeführt wird.

4. Verfahren nach Anspruch 2, **dadurch gekennzeichnet, dass** das Bilden der Nitrid- oder Oxidnitridschicht (5) des Halbleitermaterials der Dünnschicht (3) dadurch erreicht wird, dass die offenliegenden Bereiche (3a) der Dünnschicht (3) einer Atmosphäre ausgesetzt werden, die Stickstoff enthält.

5. Verfahren nach Anspruch 4, **dadurch gekennzeichnet, dass** das Bilden der Nitrid- oder Oxidnitridschicht (5) des Halbleitermaterials der Dünnschicht (3) durch das Anwenden eines Stickstoffplasmas auf die Dünnschicht (3) erreicht wird.

6. Verfahren nach Anspruch 4, **dadurch gekennzeichnet, dass** das Bilden der Nitrid- oder Oxidnitridschicht (5) des Halbleitermaterials der Dünnschicht (3) durch das Anwenden einer Temperung in einer Stickstoff enthaltenden Atmosphäre erreicht wird.

7. Verfahren nach Anspruch 3, **dadurch gekennzeichnet, dass** die Atmosphäre der Wärmebehandlung der Phase (ii) Stickstoff enthält, und dies derart, dass sich in der Phase (ii) auf der Oberfläche der offenliegenden Bereiche (3a) eine Nitrid- oder Oxidnitridschicht (5) des Halbleitermaterials der Dünnschicht (3) bildet.

8. Verfahren nach Anspruch 7, **dadurch gekennzeichnet, dass** die Behandlung der Phase (ii) über eine Dauer, die zwischen 5 und 500 Minuten liegt, und bei einer Temperatur, die zwischen 1100 und 1300°C liegt, ausgeführt wird, und dadurch, dass die Atmosphäre Stickstoff mit einer Konzentration enthält, die vorzugsweise zwischen 0,1 und 1% liegt.

## Claims

1. Method for treating a semiconductor-on-insulator structure, comprising successively a support substrate (1), a layer (2) of oxide or oxynitride of a semiconductor material and a thin semiconductor layer (3) of said semiconductor material, said method comprising the following steps:
(i) forming, on the surface of the thin layer (3), of a mask (4) in such a way as to define so-called exposed regions (3a) of said thin layer, not covered by the mask, distributed according to a first pattern, and regions (3b) covered by the mask, distributed according to a second pattern complementary to the first,
(ii) application of a heat treatment in a neutral or reducing atmosphere, and in controlled temperature and time conditions, in such a way as to induce at least one portion of the oxygen of the layer (2) of oxide or oxynitride to be diffused through the exposed regions (3a) of the thin semiconductor layer, leading to reduce the thickness of oxide or oxynitride in the regions (2b) of the layer of oxide or oxynitride (2) distributed according to said first pattern,
said method being **characterised in that** before or during the step (ii) is formed on the exposed regions (3a) a layer (5) of nitride or of oxynitride of the semiconductor material of the thin layer (3), the thickness of said layer (5) of nitride or of oxynitride being such that the ratio between the rate of diffusion of the oxygen through the exposed regions (3a) of the thin layer (3) covered with said layer (5) of nitride or of oxynitride and the rate of diffusion of the oxygen through the regions (3b) covered by the mask (4) is greater than or equal to 2.

2. Method according to claim 1, **characterised in that** the step of forming the layer (5) of nitride or of oxynitride of the semiconductor material of the thin layer (3) is carried out prior to the application of the heat treatment of the step (ii).

3. Method according to claim 1, **characterised in that** the step of forming the layer (5) of nitride or of oxynitride of the semiconductor material of the thin layer (3) is carried out during at least part of the heat treatment of the step (ii).

4. Method according to claim 2, **characterised in that** the forming of the layer (5) of nitride or of oxynitride of the semiconductor material of the thin layer (3) is obtained by exposing the exposed regions (3a) of the thin layer (3) to an atmosphere containing nitrogen.

5. Method according to claim 4, **characterised in that** the forming of the layer (5) of nitride or of oxynitride of the semiconductor material of the thin layer (3) is obtained by application of a nitrogen plasma to said thin layer (3).

6. Method according to claim 4, **characterised in that** the forming of the layer (5) of nitride or of oxynitride of the semiconductor material of the thin layer (3) is obtained by application of annealing in an atmosphere containing nitrogen.

7. Method according to claim 3, **characterised in that** the atmosphere of the heat treatment of the step (ii) contains nitrogen, in such a way that during the step (ii) is formed on the surface of the exposed regions (3a) a layer (5) of nitride or of oxynitride of the semiconductor material of the thin layer (3).

8. Method according to claim 7, **characterised in that** the treatment of the step (ii) is carried out during a duration of between 5 and 500 minutes, at a temperature between 1100 and 1300°C, and **in that** the atmosphere contains nitrogen with a concentration preferably between 0.1 and 1%.
